# EUROPEAN PATENT APPLICATION

(11) **EP 3 709 176 A1**
(43) Date of publication of application: **16.09.2020**
(21) Application number: 18873497.4
(22) Date of filing: 29.10.2018
(51) Int. Cl.: G06F 13/00

(54) **STORAGE DEVICE AND STORAGE SYSTEM**

(30) Priority: 06.11.2017 CN 201711080057
(71) Applicant: ZTE Corporation, Shenzhen, Guangdong 518057 (CN)
(72) Inventor: DAI, Qingjun, Shenzhen Guangdong 518057 (CN); GAO, Zhenzhong, Shenzhen Guangdong 518057 (CN); CHEN, Yejia, Shenzhen Guangdong 518057 (CN); HUANG, Libing, Shenzhen Guangdong 518057 (CN)
(74) Representative: Vitillo, Giuseppe
(86) International application number: PCT/CN2018/112336
(87) International publication number: WO 2019/085849

(57) **Abstract**

Provided are a storage device and a storage system. The storage device includes a back plate, multiple input-output interface cards arranged on a first mounting surface of the back plate, and multiple main control boards arranged on a second mounting surface of the back plate, the multiple input-output interface cards are mounted on the back plate through back plate connectors; at least one main control board of the multiple main control boards is provided with at least two central processing units, and interface links of the at least two central processing units are directly connected to the back plate.

## Description

This application claims priority to Chinese patent application No. 201711080057.7 filed on November 06, 2017, invention of which is incorporated herein by reference in its entirety.

### TECHNICAL FIELD

This application relates to a storage field, for example, to a storage device and storage system.

### BACKGROUND

In a related storage system, in order to support more input-output (IO) interfaces, an independent IO interface card is used for providing an external IO interface, and the IO interface cards are interconnected with a control board through a back plate.

In actual applications, since a storage device needs to support standard rack mounting, which has a width of 447mm at most. In the limitation of this size, the storage device may be equipped with up to 16 IO interface cards in one row, and a main control board may support up to 8 IO interface cards.

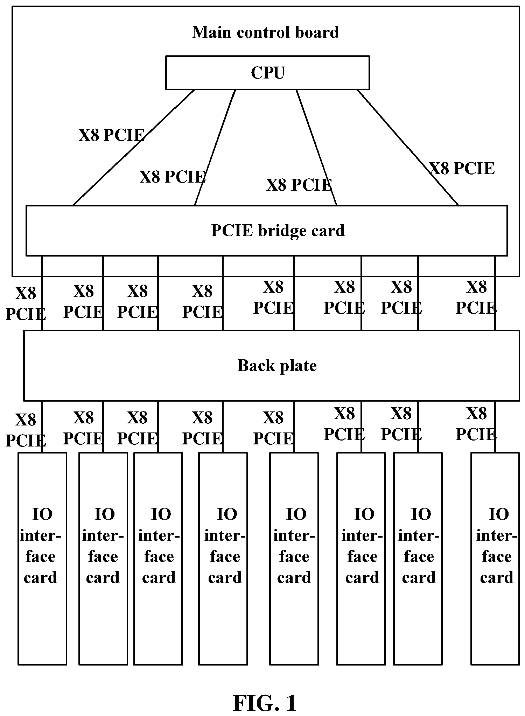

As shown in FIG. 1, a related main control board uses a central processing unit (CPU) to provide an interface link. Currently, mainstream X86 CPUs generally have 40 high-speed serial computer expansion bus standard (peripheral component interconnect express (PCIE)) interface links, and each IO interface card generally requires 8 PCIE interface links, when 8 IO interface cards are needed to be supported, a PCIE bridge card needs to be added between the CPU and the IO interface cards.

After adding the PCIE bridge card between the CPU and the IO interface cards, traffic of multiple IO interface cards needs to be sent to the CPU after centralized scheduling of the PCIE bridge card. The exchange is concentrated, which will cause processing latency when the traffic is large, an exchange bottleneck is formed, and system performance indicators are affected.

### SUMMARY

The following is a summary of the subject matter described herein in detail. This summary is not intended to limit the scope of the claims.

An embodiment of the present application provides a storage device and a storage system to avoid an exchange bottleneck caused by the related storage device which needs to add a PCIE bridge card between the CPU and the IO interface cards.

An embodiment of the present application provides a storage device. The storage device includes a back plate, multiple input-output interface cards arranged on a first mounting surface of the back plate, and multiple main control boards arranged on a second mounting surface of the back plate, the multiple input-output interface cards are mounted on the back plate through back plate connectors; at least one main control board of the multiple main control boards is provided with at least two central processing units, and interface links of the at least two central processing units are directly connected to the back plate.

An embodiment of the present application further provides a storage system. The storage system includes a mounting rack, and the storage device mounted on the mounting rack and provided by the embodiments of the present application.

Other aspects can be understood after the drawings and the detailed description are read and understood.

### BRIEF DESCRIPTION OF DRAWINGS

FIG. 1 is a structural diagram of a related storage device;
FIG. 2 is a structural diagram of a storage device provided by an embodiment of the present application;
FIG. 3 is a structural diagram of a storage device provided by an embodiment of the present application;
FIG. 4 is a structural diagram of a storage device provided by an embodiment of the present application;
FIG. 5 is a schematic diagram of a basic IO interface card provided by an embodiment of the present application;
FIG. 6 is a schematic diagram of a stacked IO interface card provided by an embodiment of the present application;
FIG. 7 is a schematic diagram of a combined IO interface card provided by an embodiment of the present application;
FIG. 8 is a structural diagram of a first application of the storage device provided by an embodiment of the present application; and
FIG. 9 is a structural diagram of a second application of the storage device provided by an embodiment of the present application.

### DETAILED DESCRIPTION

The present invention will be further described in detail through embodiments with reference to the accompanying drawings. It is to be understood that the specific embodiments described herein are merely intended to explain the present application and not to limit the present application.

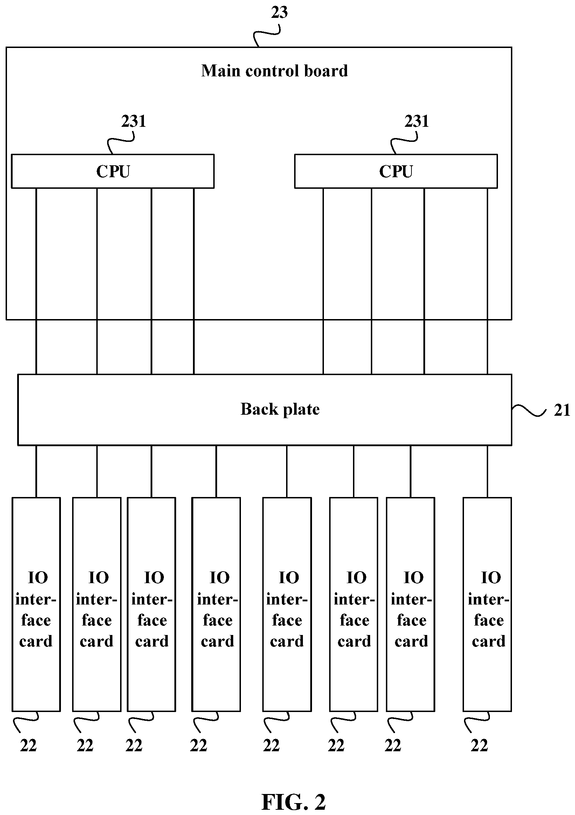

Referring to FIG. 2, a storage device provided by this embodiment includes: a back plate 21, multiple input-output interface cards 22 arranged on a first mounting surface of the back plate 21, and multiple main control boards 23 arranged on a second mounting surface of the back plate, the multiple input-output interface cards 22 are mounted on the back plate 21 through back plate connectors. At least one main control board 23 is provided with at least two central processing units 231, and interface links of the at least two central processing units 231 are directly connected to the back plate 21. FIG. 2 is a plan view of the storage device without showing all main control boards.

In some embodiments, multiple input-output interface cards has a number of 16, and multiple main control boards has a number of 2; each main control board is connected to eight input-output interface cards through back plate connectors.

In some embodiments, two main control boards are respectively provided with at least two central processing units, and a total number of interface links of the at least two central processing units is greater than or equal to a total number of interface links of the eight input-output interface cards.

In some embodiments, at least two central processing units have a same specification.

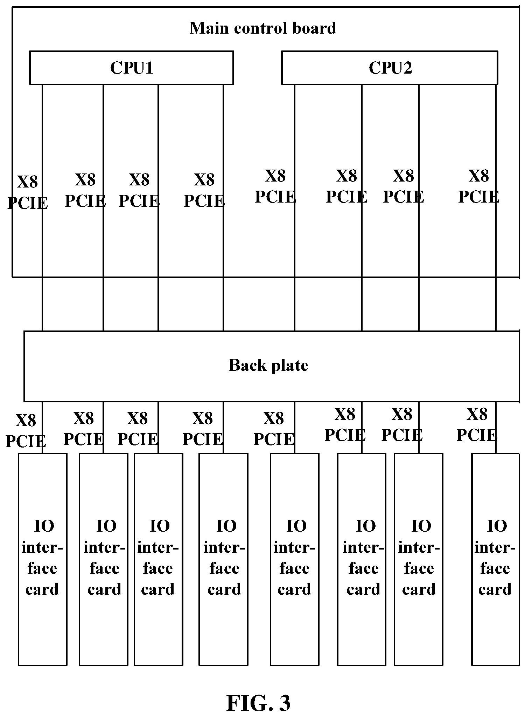

In some embodiments, as shown in FIG. 3, two central processing units are provided.

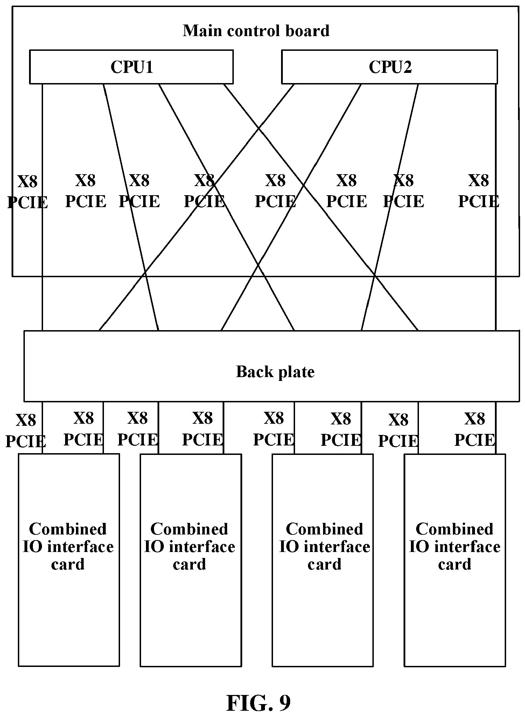

In some embodiments, as shown in FIG. 9, multiple input-output interface cards form multiple combined input-output interface cards, each combined input-output interface card includes at least two input-output interface cards.

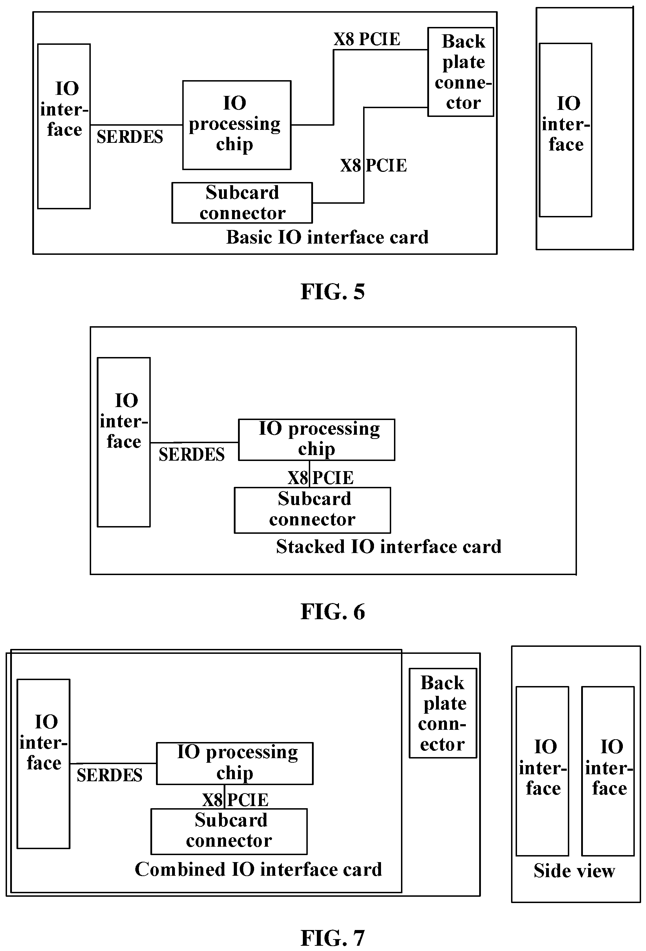

In some embodiments, as shown in FIG. 7, the at least two input-output interface cards in the combined input-output interface card are connected to the back plate through a common back plate connector.

In some embodiments, as shown in FIG. 7, a combined input-output interface card includes a basic input-output interface card and a stacked input-output interface card, the basic input-output interface card is provided with a back plate connector, and the stacked input-output interface card is connected to the back plate through the back plate connector of the basic input-output interface card.

In some embodiments, as shown in FIGs. 5 and 6, the basic input-output interface card includes a first input-output interface, a first input-output processing chip, a first subcard connector and the back plate connector; the back plate connector is connected to the first input-output processing chip through a first interface link, and the back plate connector is connected to the first subcard connector through a second interface link. The stacked input-output interface card includes a second input-output interface, a second input-output processing chip and a second subcard connector; and the second subcard connector is connected to the first subcard connector.

At the same time, the present application further provides a storage system. The storage system includes a mounting rack, and the storage device provided by the embodiments of the present application, which is mounted on the mounting rack.

In an embodiment, the IO interface cards of the storage device are mounted on the back plate through the back plate connectors, the main control board is provided with at least two central processing units, and the interface links of the at least two central processing units are directly connected to the back plate. In this way, through setting multiple CPUs on the main control board and using the interface links of the multiple CPUs to connect to the IO interface cards, it is ensured that one main control board may support a larger number of IO interface cards. Meanwhile, since the CPUs are directly connected to the IO interface cards, there is no need to set a PCIE bridge card, which avoids an exchange bottleneck caused by the related storage device which needs to add a PCIE bridge card between the CPU and the IO interface cards.

The application will be further explained in conjunction with application scenarios.

In an embodiment, taking the IO interface cards as conventional interface cards as an example, as shown in the plan view of FIG. 3, the storage device provided by this embodiment includes a back plate and sixteen IO interface cards arranged on a first mounting surface of the back plate, and two main control boards arranged on a second mounting surface of the back plate. FIG. 3 is a plan view of the storage device, half of the number of IO interface cards and main control boards may not be seen, and each main control board is provided with two CPUs, interface links of the two CPUs 231 are directly connected to the back plate. This method is compatible with related IO interface cards.

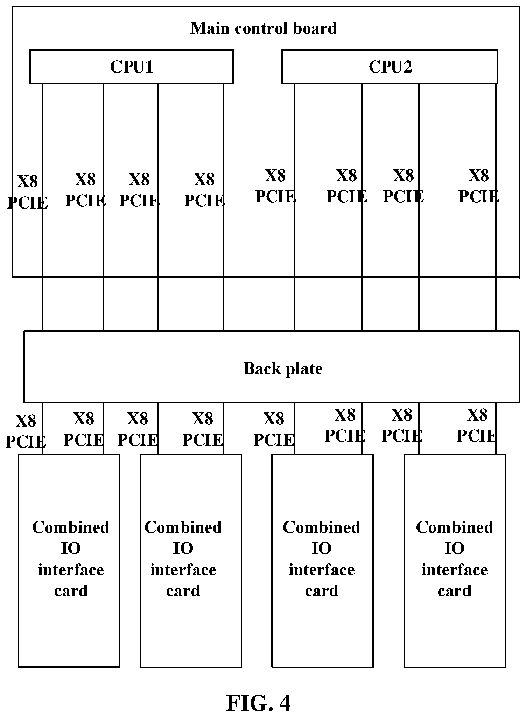

In an embodiment, taking the IO interface cards as improved IO interface cards provided by the present application as example, as shown in the plan view of FIG. 4, the storage device provided by this embodiment includes a back plate, eight combined IO interface cards arranged on the first mounting surface of the back plate, and two main control boards arranged on the second mounting surface of the back plate, FIG. 4 is the plan view of the storage device, half of the number of IO interface cards and main control boards may not be seen, and each main control board is provided with two CPUs, interface links of the two CPUs 231 are directly connected to the back plate, which may save half of the number of back plate connectors.

In an embodiment, as shown in FIG. 9, CPU1 and CPU2 are arranged on the main control board. CPU1 must be configured to be effective, and CPU2 may choose whether to be effective according to requirements.

CPU1 distributes its PCIE devices to 4 IO interface cards through the back plate in the manner of X8. For this IO interface cards that only use PCIE links of CPU1, which are called basic IO interface cards in this application; CPU2 divides its PCIE devices into 4 IO interface cards according to the manner of X8. These 4 IO interface cards may be designed as subcards mounted on the basic IO interface cards. For this IO interface cards that are only connected to the PCIE of CPU2, which are called stacked IO interface cards in this application; the stacked IO interface cards are inserted into the basic IO interface cards and combined into IO cards providing 2 groups of IO ports. This IO interface cards are called combined IO cards in this application.

In this way, when the control board configures CPU1 and CPU2 to be effective at the same time, and when the combined IO cards are configured, a main control board may provide external interfaces for 8 IO cards at most.

As shown in FIG. 5, a basic IO interface card is configured with a back plate connector and supports two X8 PCIE links, where one of the two links is connected to an IO processing chip on the basic IO interface card, and the IO processing chip is connected to an IO interface module through a serdes; the other X8 PCIE link is connected to a subcard connector on the basic interface card. This subcard connector is used for connecting the stacked IO interface card; at the same time, the basic IO interface card is configured with a box body, and corresponding IO interfaces are provided externally through a box panel.

As shown in FIG. 6, a stacked IO interface card is equipped with a subcard connector, which supports an X8 PCIE link. This X8 PCIE is connected to an IO processing chip on the stacked IO interface card, and the IO processing chip is connected to an IO interface module through a serdes, the stacked IO interface card is only used with the basic IO interface card, and a box body is not configured separately.

As shown in FIG. 7, the stacked IO interface card is mounted on the basic IO interface card to form a combined IO interface card. The basic IO interface card configures another X8 PCIE on the back plate connector to be connected to the IO processing chip on the stacked IO interface card through the subcard connector of the back plate and the subcard connector of the stack IO interface card. The combined IO interface card is provided with a box body. The basic IO interface card and the stacked IO interface card provide corresponding external IO interfaces through the box panel. The combined interface card provides twice of the number of IO interfaces as that provided by the basic IO interface card.

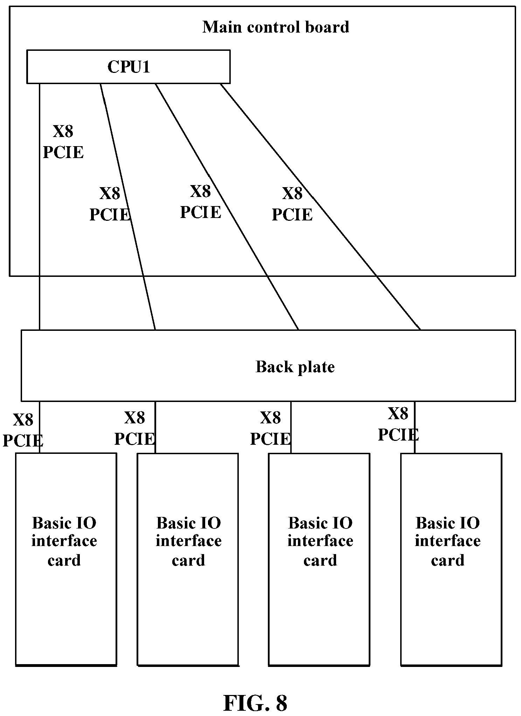

As shown in FIG. 8, the control board only configures CPU1 to be effective, and CPU1 outputs four X8 PCIE links, which are connected to four basic IO interface cards through the back plate, in this case, the PCIE links between the CPU and the IO cards are consistent, no exchange bottleneck exists. A control board under this configuration may provide interfaces for four IO cards.

As shown in FIG. 9, the control board configures CPU1 and CPU2 to be effective, and CPU1 outputs four X8 PCIE links, which are connected to four basic IO interface cards through the back plate. CPU2 outputs four X8 PCIE links, which are connected to four stacked IO interface cards through the back plate. In this case, PCIE links between CPUs and IO cards are consistent, no exchange bottleneck exists. A control board under this configuration may provide interfaces for eight IO cards.

According to the above descriptions, the basic IO interface cards, the stacked IO interface cards, the combined IO interface cards and the CPU configuration of the control board may effectively avoid a case where a disk array in the storage field requires multiple IO interfaces, one control board may provide interfaces for eight IO cards externally without exchange bottleneck.

According to the storage device and the storage system provided by the embodiments of the present application, the IO interface cards of the storage device are mounted on the back plate through the back plate connectors, the main control board is provided with at least two central processing units, and the interface links of the at least two central processing units are directly connected to the back plate. In this manner, by setting multiple CPUs on the main control board and using the interface links of these multiple CPUs to connect to the IO interface cards, it is ensured that one main control board may support a larger number of IO interface cards. Meanwhile, since the CPUs are directly connected to the IO interface cards, there is no need to set a PCIE bridge card, which avoids an exchange bottleneck caused by the related storage device which needs to add a PCIE bridge card between the CPUs and the IO interface cards.

It should be understood by those skilled in the art that each of the modules or the steps in the above-mentioned embodiments of the present application may be implemented by a general-purpose computing device. They may be concentrated on a single computing device or distributed over a network composed of multiple computing devices. For example, they may be implemented by program codes executable by computing devices, so that they may be stored in a computer storage medium (such as a read only memory (ROM)/random access memory (RAM)), a magnetic disk or an optical disk and executed by computing devices. And in some circumstances, the illustrated or described steps may be executed in sequences different from those described herein, or the modules or steps may be made into various integrated circuit modules separately, or multiple modules or steps therein may be made into a single integrated circuit module for implementation. Therefore, the present application is not limited to any specific combination of hardware and software.

## Claims

1. A storage device, comprising: a back plate, a plurality of input-output interface cards arranged on a first mounting surface of the back plate, and a plurality of main control boards arranged on a second mounting surface of the back plate, wherein
the plurality of input-output interface cards is mounted on the back plate through back plate connectors, at least one main control board of the plurality of main control boards is provided with at least two central processing units, and interface links of the at least two central processing units are directly connected to the back plate.

2. The storage device of claim 1, wherein the plurality of input-output interface cards has a number of 16, the plurality of main control boards has a number of 2, and each of the plurality of main control boards is connected to eight input-output interface cards through the back plate connectors.

3. The storage device of claim 2, wherein each of two main control boards is provided with at least two central processing units respectively, and a total number of interface links of the at least two central processing units is greater than or equal to a total number of interface links of eight input-output interface cards.

4. The storage device of claim 1, wherein the at least two central processing units have a same specification.

5. The storage device of claim 1, wherein the at least two central processing units have a number of 2.

6. The storage device of any one of claims 1 to 5, wherein the plurality of input-output interface cards forms a plurality of combined input-output interface cards, and each of the plurality of combined input-output interface cards comprises at least two input-output interface cards.

7. The storage device of claim 6, wherein the at least two input-output interface cards in each of the plurality of combined input-output interface cards are connected to the back plate through a common back plate connector.

8. The storage device of claim 7, wherein each of the plurality of combined input-output interface cards comprises a basic input-output interface card and a stacked input-output interface card, the basic input-output interface card is provided with a back plate connector, and the stacked input-output interface card is connected to the back plate through the back plate connector of the basic input-output interface card.

9. The storage device of claim 8, wherein the basic input-output interface card comprises a first input-output interface, a first input-output processing chip, a first subcard connector and the back plate connector, and the back plate connector is connected to the first input-output processing chip through a first interface link, and the back plate connector is connected to the first subcard connector through a second interface link; and the stacked input-output interface card comprises a second input-output interface, a second input-output processing chip and a second subcard connector, and the second subcard connector is connected to the first subcard connector.

10. A storage system, comprising: a mounting rack, and the storage device of any one of claims 1 to 9 mounted on the mounting rack.
